Europäisches Patentamt

European Patent Office

Office européen des brevets

(19)

(11) **EP 0 741 881 B1**

(12) **EUROPÄISCHE PATENTSCHRIFT**

(45) Veröffentlichungstag und Bekanntmachung des Hinweises auf die Patenterteilung:
**15.07.1998 Patentblatt 1998/29**

(21) Anmeldenummer: **95905052.7**

(22) Anmeldetag: **14.01.1995**

(51) Int Cl.6: **G05F 1/46**

(86) Internationale Anmeldenummer:
**PCT/DE95/00039**

(87) Internationale Veröffentlichungsnummer:
**WO 95/20783 (03.08.1995 Gazette 1995/33)**

(54) **INTEGRIERTE SCHALTUNG**

INTEGRATED CIRCUIT

CIRCUIT INTEGRE

(84) Benannte Vertragsstaaten:
**DE GB IT**

(30) Priorität: **27.01.1994 DE 4402340**

(43) Veröffentlichungstag der Anmeldung:
**13.11.1996 Patentblatt 1996/46**

(73) Patentinhaber: **ROBERT BOSCH GMBH**
**70442 Stuttgart (DE)**

(72) Erfinder:
- **MINDL, Anton**
  **D-31141 Hildesheim (DE)**
- **MICHEL, Hartmut**
  **D-72762 Reutlingen (DE)**
- **BIRECKOVEN, Bernd**
  **D-72127 Kusterdingen (DE)**
- **UEBELE, Manfred**
  **D-72760 Reutlingen (DE)**
- **NELLE, Ulrich**
  **D-72820 Sonnenbühl (DE)**

(74) Vertreter: **Friedmann, Jürgen, Dr.-Ing. et al**
**Robert Bosch GmbH**
**Abteilung ZGE2**
**Postfach 30 02 20**
**70442 Stuttgart (DE)**

(56) Entgegenhaltungen:
**EP-A- 0 189 885      EP-A- 0 498 727**
**EP-A- 0 557 739      FR-A- 2 281 603**

EP 0 741 881 B1

## Beschreibung

### Stand der Technik

Die Erfindung geht aus von einer integrierten Schaltung nach der Gattung des unabhängigen Anspruchs 1. Aus dem Buch von Tietze und Schenk, 9. Auflage, Seite 523 ist bereits eine Schaltung mit einem Leistungstransistor bekannt, bei dem ein Stromregelungstransistor und ein Strommeßwiderstand vorgesehen sind. Durch den Spannungsabfall am Strommeßwiderstand wird der Stromregelungstransistor angesteuert.

### Vorteile der Erfindung

Die erfindungsgemäße integrierte Schaltung mit den kennzeichnenden Merkmalen des unabhängigen Anspruchs 1 hat demgegenüber den Vorteil, daß der Stromfluß durch den Leistungstransistor in Abhängigkeit von der Bauteiltemperatur verringert wird. Durch diese Maßnahme erfolgt ein Schutz des Leistungstransistors vor Überhitzung.

Durch die in den abhängigen Ansprüchen aufgeführten Maßnahmen sind vorteilhafte Weiterbildungen und Verbesserungen der im unabhängigen Anspruch angegebenen integrierten Schaltung möglich. Durch die Verwendung eines Temperaturmeßtransistors mit größerer Emitterfläche als der Stromreglungstransistor kann die Temperaturabhängigkeit der Schaltung besonders exakt kontrolliert werden. Durch die Verwendung eines parallel zum Leistungstransistor geschalteten Strommeßtransistors erfolgt die Strommessung mit geringen Verlusten, da im Emitterkreis kein Meßwiderstand angeordnet werden muß. Durch die Verwendung eines Spannungsteilers kann das Schaltpotential für den Stromregelungstransistor und den Temperaturmeßtransistor auf einen entsprechenden Pegel eingestellt werden. Durch die Verwendung von in Durchlaßrichtung geschalteten Dioden kann der positive Temperaturkoeffizient der Stromregelung auf den gewünschten Wert eingestellt werden. Durch die entsprechenden Dimensionsierung eines Koppelwiderstands wird die Größe der thermischen Abregelung eingestellt. Die Beeinflussung des Potentials durch den Stromfluß des weiteren Transistors erfolgt besonders einfach über einen dritten Knoten des Spannungsteilers. Durch die Verwendung von Darlington-Transistoren oder weiteren Stromregelungstransistoren können die entsprechenden Verstärkungen erhöht werden.

### Zeichnungen

Ausführungsbeispiele der Erfindung sind in den Zeichnungen dargestellt und in der nachfolgenden Beschreibung näher erläutert. Es zeigen Figur 1 ein Schaltungsschema der integrierten Schaltung, Figur 2 die integrierte Schaltung in Verbindung mit einer induktiven Last und Figur 3 ein Diagramm mit den zeitlichen Verlauf des Stroms durch die integrierte Schaltung.

### Beschreibung der Erfindung

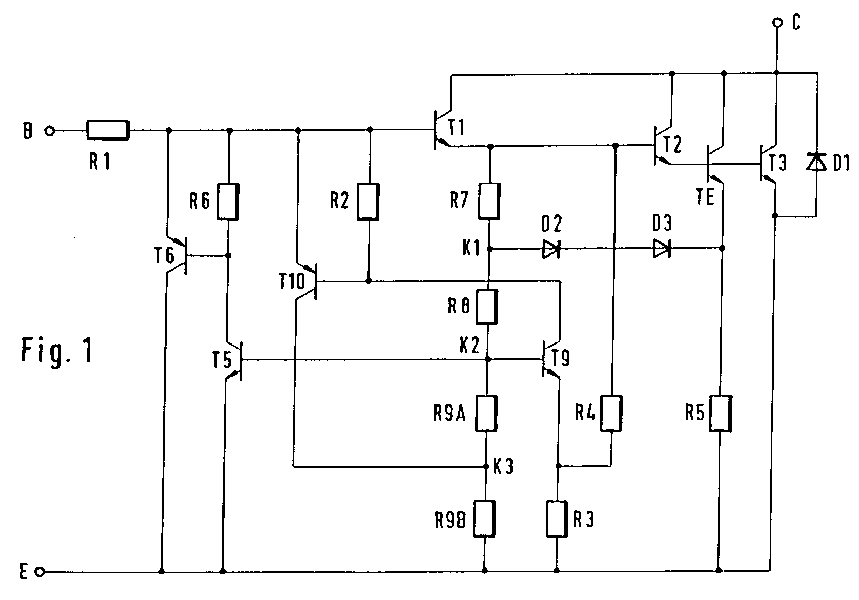

In der Figur 1 wird ein Schaltbild der integrierten Schaltung gezeigt. Die Schaltung weist einen Kollektoranschluß C, einen Basisanschluß B, einen Emitteranschluß E und Transistoren T1, T2, T3, TE, T5, T6, T9 und T10 auf. Die Transistoren T1, T2, TE, T3, T9, T5 sind als npn-Transistoren ausgestaltet. Die Transistoren T10 und T6 sind als pnp-Transistoren ausgebildet. Es versteht sich von selbst, daß durch eine entsprechende Änderung der anliegenden Potentiale auch entsprechend npn- und pnp-Transistoren vertauscht werden können. Die Transistoren T1, T2, T3 arbeiten in Darlington-Schaltung, dies ist jedoch keine notwendige Voraussetzung für die prinzipielle Funktion der vorgestellten Schaltung. Der Basisanschluß B ist über einen Widerstand R1 mit dem Basisanschluß des ersten Transistors T1 verbunden. Der Kollektor des Transistors T1 ist mit dem Kollektoranschluß C verbunden. Der Emitter des Transistors T1 ist mit der Basis des Transistors T2 verbunden. Der Kollektor des Transistors T2 ist mit dem Kollektoranschluß verbunden. Der Emitter des Kollektors T2 ist mit der Basis des Strommeßtransistors TE und Transistors T3 verbunden. Die Kollektoren des Strommeßtransistors TE und des Transistors T3 sind mit dem Kollektoranschluß verbunden. Der Emitter des Strommeßtransistors TE ist über einen Widerstand R5 mit dem Emitteranschluß E verbunden. Der Emitter des Transistors T3 ist mit dem Emitteranschluß verbunden. Der Emitteranschluß E ist mit der Anode einer Diode D1 verbunden. Der Kollektoranschluß ist mit der Kathode der Diode D1 verbunden. Der Emitter des Transistors T6 ist mit der Basis des Transistors T1 verbunden. Der Kollektor des Transistors T6 ist mit dem Emitteranschluß verbunden. Die Basis des Transistors T6 ist über einen Widerstand R6 mit der Basis des Transistors T1 verbunden. Die Basis des Transistors T6 ist mit dem Kollektor des Transistors T5 verbunden. Der Emitter des Transistors T5 ist mit dem Emitteranschluß E verbunden. Die Basis des Transistors T5 ist mit dem Knoten K2 eines Spannungsteilers (gebildet aus R7, R8, R9A und R9B) verbunden. Der Emitter des Transistors T10 ist mit der Basis des Transistors T1 verbunden. Der Kollektor des Transistors T10 ist mit dem Knoten K3 des o. g. Spannungsteilers verbunden. Die Basis des Transistors T10 ist über einen Widerstand R2 mit der Basis des Transistors T1 verbunden. Ein Transistor T9 ist mit seinem Kollektor mit der Basis des Transistors T10 verbunden. Die Basis des Transistors T9 ist mit dem Knoten K2 verbunden. Der Emitter des Transistors T9 ist über einen Widerstand R3 mit dem Emitteranschluß E verbunden. Der Spannungsteiler wird durch die Widerstände R7, R8, R9A und R9B gebildet. Der Widerstand R7 ist zwischen dem Emitter des Transistors T1 und einem Knoten K1 angeordnet. Der Widerstand R8 ist zwischen dem Knoten K1 und dem Knoten K2 angeordnet.

Der Widerstand R9A ist zwischen dem Knoten K2 und dem Knoten K3 angeordnet. Der Widerstand R9B ist zwischen dem Knoten K3 und dem Emitteranschluß E angeordnet. Der Knoten K1 ist mit der Anode einer Diode D2 verbunden. Die Kathode der Diode D2 ist mit der Anode einer Diode D3 verbunden. Die Kathode der Diode D3 ist mit dem Emitter des Strommeßtransistors TE verbunden. Der Emitter des Transistors T1 ist über einen Koppelwiderstand R4 mit dem Emitter des Temperaturmeßtransistors T9 verbunden.

Die Darlington-Transistoren T1, T2, T3 bilden einen Leistungstransistor, mit dem eine Last zwischen Kollektor und Emitter entsprechend geschaltet werden kann. Der Strommeßtransistor TE ist parallel zum letzten Transistor T3 geschaltet. Durch diesen Transistor TE fließt ein Strom, der eineindeutig abhängig ist vom Stromfluß durch den Transistor T3. Dieser Strom erzeugt am Widerstand R5 einen Spannungsabfall. Da durch den parallelgeschalteten Strommeßtransistor TE nur ein geringer Strom fließt, wird die Verlustleistung gering gehalten. Durch die Widerstände R7, R8, R9A und R9B wird ein Spannungsteiler gebildet. Durch die Verbindung des Knotens K1 dieses Spannungsteilers mit dem Emitter des Strommeßtransistors TE wird bei steigendem Strom durch den Transistor TE die Spannung am Knoten K2 des spannungsteilers angehoben. Mit dem Knoten K2 ist die Basis des Stromregelungstransistors T5 und die Basis des Temperaturmeßtransistors T9 verbunden. Der Transistor T9 weist eine wesentlich größere Emitterfläche auf als der Transistor T5. Weiterhin hat der Widerstand R2 einen größeren Wert als R6. Infolge der geringeren Stromdichte in T9 im Vergleich zu T5 weist T9 eine niedrigere Basisemitterspannung als T5 auf. Weiterhin ist der negative Temperaturkoeffizient der Basisemitterspannung des Temperaturmeßtransistors T9 wesentlich größer als derjenige des Transistors T5. Unterhalb einer vorgegebenen Temperatur bewirkt der Spannungsabfall am Widerstand R3, daß der Spannungsabfall am Widerstand R5 nur auf den Stromregelungstransistor T5 wirkt. Bei Erreichen des vorgesehenen Regelstromes durch den Leistungstransistor T1, T2, T3 wird der Stromregelungstransistor T5 aufgesteuert, der einen Teil des Basisstroms direkt an den Emitteranschluß ableitet. Zur Verstärkung ist hier noch ein weiterer Stromregelungstransistor T6 vorgesehen, der durch den Stromfluß durch den Transistor T5 aufgesteuert wird. Vom Prinzip her arbeitet die Schaltung jedoch auch ohne den Transistor T6. Oberhalb einer vorgegebenen Temperatur wird dann auch der Temperaturmeßtransistor T9 aktiviert. über den Widerstand R2 und R3 wird dann ein weiterer Stromfluß zwischen dem Basisanschluß B und dem Emitteranschluß E ermöglicht. Bei diesem Stromfluß stellt sich am Basisanschluß von T10 ein Potential ein, welches den Transistor T10 aufsteuert. Da der Kollektor des Transistors T10 mit dem Knoten K3 des Spannungsteilers verbunden ist, wird durch den Stromfluß durch T10 das Potential am Knoten K3 bzw. am Knoten K2 angehoben.

Durch diese Rückkopplung wird somit die Spannung am Knoten K2 derart beeinflußt, daß der Transistor T5 weiter aufgesteuert, so daß der Stromfluß zwischen Kollektor und Emitter durch den Leistungstransistor T1, T2, T3 verringert wird. Eine nochmalige Verringerung des Stromflusses durch den Leistungstransistor T1, T2, T3 nach Aktivierung von T10 wird durch den Widerstand R4 verursacht. Durch das Einsetzen der thermischen Abregelung wird das Potential an der Basis des Transistors T2 verringert. Über den Kopplungswiderstand R4 führt dies zu einer Verringerung des Potentials am Emitter des Temperaturmeßtransistors T9. Dies führt zu einer weiteren Aufsteuerung von T9, die eine Absenkung des Stromes durch den Leistungstransistor zur Folge hat. Nachdem also der Temperaturmeßtransistor T9 einmal aufgesteuert wurde, und solange der Stromfluß durch den Leistungstransistor nicht durch andere Maßnahmen gestoppt wird, bleibt die thermisch bedingte Abregelung des Kollektor-Emitterstromes des Leistungstransistors T1, T2, T3 erhalten.

Der Einsatz der thermischen Abregelung wird bestimmt durch das Verhältnis von thermisch gleichlaufenden Widerständen, durch die Flächen der Transistoren T5, T6, T9, T10 und durch die Basisemitterspannung $U_{BE}$ (T2, T3) der Transistoren T2 und T3. Die Basisemitterspannung $U_{BE}$ (T9) des Transistors T9 hängt wegen der größeren Emitterfläche des Transistors T9 wesentlich stärker von der Temperatur ab als die Basisemitterspannung $U_{BE}$ (T5) des Transistors T5. Der Transistor T10 wird leitend, wenn gilt:

$$U_{BE} (T5) = U_{BE} (T9) +$$

$$R4/_{(R3+R4)} [R3/_{R2} U_{BE} (T10) + R3/_{R4} U_{BE} (T2,T3)]$$

Die Basisemitterspannung des Leistungstransistor T2, T3 weist dabei die größte Streubreite auf. Da diese Größe jedoch nur mit dem sehr kleinen Widerstandsverhältnis R3/R4 eingeht, ist die Einsatztemperatur der thermischen Abregelung nur mit sehr geringen Toleranzen behaftet. Ein Test der Schaltung ist durch externe R3-Verkleinerung auch unterhalb der vorgesehenen Ansprechtemperatur möglich.

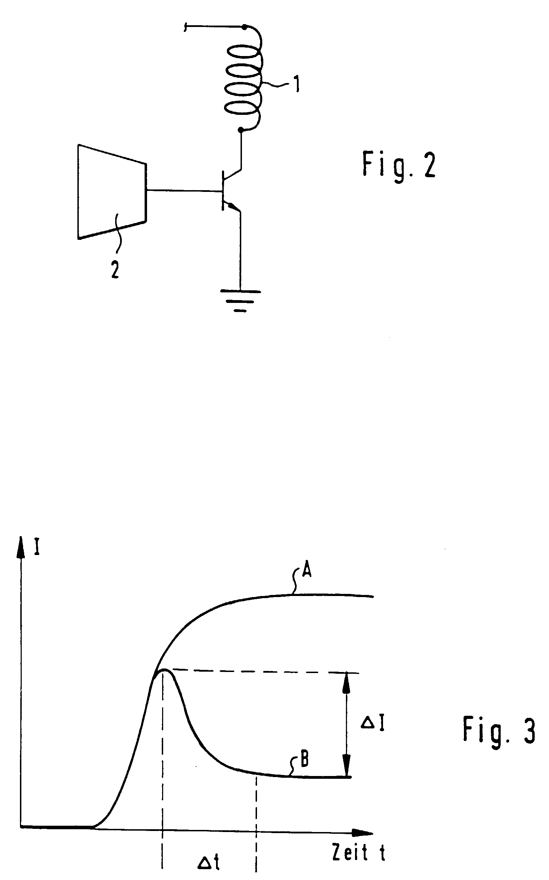

In der Figur 2 ist eine Anwendung der erfindungsgemäßen Schaltung zum Schalten einer induktiven Last gezeigt. Bei der durch die Spule 1 dargestellten induktiven Last kann es sich beispielsweise um eine Zündspule handeln, die durch die, hier vereinfachend als Transistor dargestellte Schaltung mit einem Massepotential verbunden werden kann. Die Ansteuerung der Schaltung erfolgt beispielsweise durch eine Steuerung 2. In der Figur 3 wird der Kollektorstrom I als Funktion der Zeit für die Anordnung nach Figur 2 gezeigt. Die Kurve A zeigt die zeitlichen Verlauf des Kollektorstromes, wenn nur die Strombegrenzung durch den Strombegrenzungstransistor T5 und den Transistor T6 wirksam ist. Die Kurve B beschreibt den zeitlichen Verlauf des Kollektorstromes, wenn zusätzlich die thermische Regelung durch den Temperaturmeßtransistor T9 eingreift. Die Differenz ΔI, die Absenkung des Stromniveaus nach Ansprechen der Schaltung, hängt dabei im wesentlichen von der Dimensionierung des Widerstandes R4 ab. Die Zeit Δt kann in gewissen Grenzen durch geeignete Plazierung des Temperaturmeßtransistors T9 und des Stromregelungstransistors T5 relativ zur Endstufe T3 beeinflußt werden.

Die gezeigte Schaltung eignet sich besonders gut zur Beschaltung mit einer induktiven Last, wie z. B. mit einer Zündspule; dies ist in der Figur 2 gezeigt. Durch ein entsprechendes Signal der Steuerung 2 wird der Transistor geöffnet, und so die Spule 1 zwischen dem Kollektor-Emitter-Potential des durchgeschalteten Transistors und einer Versorgungsspannung angeordnet. Aufgrund der Induktivität wird beim Laden der Spule 1 der Strom durch Spule und den Transistor langsam ansteigen. In dieser Phase arbeitet der Darlingtontransistor in der Sättigung, wobei aufgrund der niedrigen Kollektor-Emitter- Spannung keine hohe Verlustleistung auftritt. Bei normaler Betriebsart der Zündung sollte durch die Steuerung 2 der Transistor abgeschaltet werden, bevor der Stromfluß durch die Spule und den Transistor zeitlich konstant wird, da sonst der Transistor den größten Anteil der Versorgungsspannung übernehmen muß, wobei hohe Verlustleistungen abgeführt werden müssen. Wenn das Abschalt-Signal jedoch aufgrund einer Störung ausfällt, und der Stromfluß durch den Transistor andauert, wird durch die dadurch hervorgerufene Erwärmung die thermische Abregelung aktiviert, die den Stromfluß durch den Transistor auf unproblematische Werte reduziert. Da diese Abregelung kontinuierlich erfolgt, kann dabei das Auftreten von steilen Spannungsanstiegen zwischen Kollektor und Emitter, die ungewollte Zündfunken nach sich ziehen könnten, vermieden werden. Weiterhin setzt die thermische Abregelung nur ein, wenn bei hoher Temperatur ein großer Strom durch die Schaltung fließt. Wenn der Stromfluß durch die Induktivität der Spule begrenzt wird, entsteht entsprechend der obigen Ausführungen im Transistor keine hohe Verlustleistung - und damit keine signifikante Temperaturerhöhung, so daß die thermische Abregelung nicht aktiviert wird. Bei Betrieb der Schaltung in Zündungsanwendungen, bei denen zwar die Temperatur hoch ist, der durch die Schaltung fließende Strom jedoch durch die Induktivität und nicht durch die Stromregelung der vorgestellten Schaltung begrenzt wird, kann somit die Zündspule noch korrekt geladen werden, so daß auch bei hoher Temperatur unter normalen Betriebsbedingungen eine uneingeschränkte Funktion der Schaltung sichergestellt ist.

Die Diode D1 arbeitet als Inversdiode, indem sie negative Kollektor-Emitter-Spannungen auf geringe Werte begrenzt, um z. B. in Zündanwendungen die von der Sekundärseite der Zündspule zurücktransformierten hochfrequenten Schwingungen zu bedämpfen.

Die Dioden D2 und D3 sind bei Normalbetrieb der Schaltung in Flußrichtung geschaltet. An diesen Dioden fällt daher eine Spannung ab, die einen negativen Temperaturkoeffizienten aufweist. Dieser negative Temperaturkoeffizient wird dazu benutzt, den Temperaturkoeffizienten der Stromregelung auf den gewünschten Wert einzustellen. Somit wird das Temperaturverhalten der Schaltung hauptsächlich durch die thermischen Eigenschaften des Temperaturmeßtransistors T9 definiert. Die Ansprechtemperatur der thermischen Stromregelung kann somit exakt eingestellt werden.

**Patentansprüche**

1. Integrierte Schaltung mit einem Leistungstransistor (T1,T2,T3) und einem Strommeßwiderstand (R5), wobei durch Abgriff des Spannungsabfall am Strommeßwiderstand (R5) der durch den Leistungstransistor (T1,T2,T3) fließende Strom meßbar ist, mit einem Stromregelungstransistor (T5) dessen Kollektor über einen Widerstand (R6) mit der Basis und dessen Emitter mit dem Emitter des Leistungstransistors (T1,T2,T3) verbunden sind, und dessen Basis vom Spannungsabfall am Strommeßwiderstand (R5) angesteuert wird, dadurch gekennzeichnet, daß ein Temperaturmeßtransistor (T9) vorgesehen ist, der ab einer vorbestimmten Temperatur einen weiteren Transistor (T10) ansteuert, und daß durch den durch den weiteren Transistor (T10) fließenden Strom die an der Basis des Stromregelungstransistors (T5) anliegende Spannung derart beeinflußt wird, daß der Stromfluß durch den Leistungstransistor (T1, T2,T3) verringert wird.

2. Integrierte Schaltung nach Anspruch 1, dadurch gekennzeichnet, daß der Temperaturmeßtransistor (T9) eine größere Emitterfläche aufweist als der Stromregelungstransistor (T5), daß die Basisanschlüsse von Stromregelungstransistor (T5) und Temperaturmeßtransistor (T9) auf dem gleichen Potential liegen, und daß der Emitter des Temperaturmeßtransistors (T9) über einen Widerstand (R3) mit dem Emitter des Leitungstransistors (T1, T2, T3) verbunden ist.

3. Integrierte Schaltung nach Anspruch 2, dadurch gekennzeichnet, daß zum Leistungstransistor (T1, T2, T3) ein Strommeßtransistor (TE) parallel geschaltet ist, und daß der Emitter des Strommeßtransitors (TE) über den Strommeßwiderstand (R5) mit dem Emitter des Leistungstransistors (T1, T2, T3) verbunden ist.

4. Integrierte Schaltung nach Anspruch 3, dadurch gekennzeichnet, daß ein Spannungsteiler (R7, R8, R9A, R9B) vorgesehen ist, der mit einem ersten Knoten (K1) mit dem Emitter des Strommeßtransistors (T9) verbunden ist und daß ein weiterer Knoten (K2) des Spannungsteilers (R7, R8, R9A, R9B) mit der Basis von Stromregelungstransistor (T5) und Temperaturmeßtransistor (T9) verbunden ist.

5. Integrierte Schaltung nach Anspruch 4, dadurch gekennzeichnet, daß die Verbindung zwischen dem ersten Knoten (K1) und dem Emitter des Strommeßtransistors (TE) durch mindestens eine, bei Normalbetrieb des Leistungstransitors (T1, T2, T3) in Durchlaßrichtung geschaltete, Diode (D2, D3) erfolgt.

6. Integrierte Schaltung nach einem der vorhergehenden Ansprüche, dadurch gekennzeichnet, daß ein Koppelwiderstand (R4) vorgesehen ist, der den Emitter des Temperaturmeßtransistor (T9) mit der Basis des Leistungstransistors (T1, T2, T3) verbindet.

7. Integrierte Schaltung nach Anspruch 4 bis 6, dadurch gekennzeichnet, daß ein dritter Knoten (K3) des Spannungsteilers (R7, R8, R9A, R9B) mit dem Kollektor des weiteren Transistors (T10) verbunden ist.

8. Integrierte Schaltung nach einem der vorhergehenden Ansprüche, dadurch gekennzeichnet, daß der Leistungstransistor (T1, T2, T3) als Darlingtontransistor ausgebildet ist.

9. Integrierte Schaltung nach einem der vorhergehenden Ansprüche, dadurch gekennzeichnet, daß der Stromregeltransistor (T5) einen weiteren Stromregeltransistor (T6) aufsteuert.

**Claims**

1. Integrated circuit having a power transistor (T1, T2, T3) and a current-measuring resistor (R5), it being possible to measure the current flowing through the power transistor (T1, T2, T3) by tapping the voltage drop at the current-measuring resistor (R5), having a current-regulating transistor (T5) whose collector is connected to the base via a resistor (R6) and whose emitter is connected to the emitter of the power transistor (T1, T2, T3), and whose base is driven by the voltage drop at the current-measuring resistor (R5), characterized in that a temperature-measuring transistor (T9) which drives a further transistor (T10) above a predetermined temperature is provided, and in that the voltage present at the base of the current-regulating transistor (T5) is influenced by the current flowing through the further transistor (T10), such that the current flow is reduced by the power transistor (T1, T2, T3).

2. Integrated circuit according to Claim 1, characterized in that the temperature-measuring transistor (T9) has a larger emitter face than the current-regulating transistor (T5), in that the base terminals of the current-regulating transistor (T5) and temperature-measuring transistor (T9) are at the same potential, and in that the emitter of the temperature-measuring transistor (T9) is connected to the emitter of the power transistor (T1, T2, T3) via a resistor (R3).

3. Integrated circuit according to Claim 2, characterized in that a current-measuring transistor (TE) is connected in parallel with the power transistor (T1, T2, T3), and in that the emitter of the current-measuring transistor (TE) is connected to the emitter of the power transistor (T1, T2, T3) via the current-measuring resistor (R5).

4. Integrated circuit according to Claim 3, characterized in that a voltage divider (R7, R8, R9A, R9B) which is connected by a first node (K1) to the emitter of the current-measuring transistor (T9) is provided, and in that a further node (K2) of the voltage divider (R7, R8, R9A, R9B) is connected to the base of the current-regulating transistor (T5) and temperature-measuring transistor (T9).

5. Integrated circuit according to Claim 4, characterized in that the connection between the first node (K1) and the emitter of the current-measuring transistor (TE) is made by means of at least one diode (D2, D3) which is connected in the conducting direction when the power transistor (T1, T2, T3) is operating normally.

6. Integrated circuit according to one of the preceding claims, characterized in that a coupling resistor (R4) which connects the emitter of the temperature-measuring transistor (T9) to the base of the power transistor (T1, T2, T3) is provided.

7. Integrated circuit according to Claim 4 to 6, characterized in that a third node (K3) of the voltage divider (R7, R8, R9A, R9B) is connected to the collector of the further transistor (T10).

8. Integrated circuit according to one of the preceding claims, characterized in that the power transistor (T1, T2, T3) is designed as a Darlington transistor.

9. Integrated circuit according to one of the preceding claims, characterized in that the current-regulating transistor (T5) biases a further current-regulating transistor (T6) to conduct.

**Revendications**

1. Circuit intégré comprenant un transistor de puissance (T1, T2, T3) et une résistance de mesure de l'intensité (R5), l'intensité qui passe à travers le transistor de puissance (T1, T2, T3) pouvant être mesurée en prélevant la chute de tension sur la résistance de mesure de l'intensité (R5), un transistor de réglage de l'intensité (T5), dont le collecteur est relié par une résistance (R6) à la base et dont l'émetteur est relié à l'émetteur du transistor de puissance (T1, T2, T3), et dont la base est commandée par la chute de tension sur la résistance de mesure de l'intensité (R5),
caractérisé en ce que

   - l'on prévoit un transistor de mesure de la température (T9), qui commande à partir d'une température prédéterminée un autre transistor (T10) et
   - la tension qui est appliquée sur la base du transistor de réglage de l'intensité (T5) est influencée par l'intensité qui passe à travers l'autre transistor (T10) d'une manière telle que le passage de l'intensité à travers le transistor de puissance(T1, T2, T3) est réduit.

2. Circuit intégré selon la revendication 1,
caractérisé en ce que

   - le transistor de mesure de la température (T9) présente une surface d'émetteur plus grande que le transistor de réglage de l'intensité (T5),
   - les raccords des bases du transistor de réglage de l'intensité (T5) et du transistor de mesure de la température (T9) se trouvent au même potentiel et
   - l'émetteur du transistor de mesure de la température(T9) est relié par une résistance (R3) à l'émetteur du transistor de puissance (T1, T2, T3).

3. Circuit intégré selon la revendication 2,
caractérisé en ce que

   - l'on met un transistor de mesure de l'intensité (TE) en parallèle au transistor de puissance (T1, T2, T3) et
   - l'émetteur du transistor de mesure (TE) est relié par l'intermédiaire de la résistance de mesure de l'intensité (R5) à l'émetteur du transistor de puissance (T1, T2, T3).

4. Circuit intégré selon la revendication 3,
caractérisé en ce que

   - l'on prévoit un diviseur de tension (R7, R8, R9A, R9B), qui est relié à un premier noeud (K1) à l'émetteur du transistor de mesure de l'intensité (T9) et

   - un autre noeud (K2) du diviseur de tension (R7, R8, R9A, R9B) est relié à la base du transistor de réglage de l'intensité (T5) et du transistor de mesure de la température (T9).

5. Circuit intégré selon la revendication 4,
caractérisé en ce que
la liaison entre le premier noeud (K1) et l'émetteur du transistor de mesure de l'intensité (TE) a lieu à travers au moins une diode (D2, D3), qui est montée dans le sens passant quand le transistor de puissance (T1, T2, T3) fonctionne normalement.

6. Circuit intégré selon l'une des revendications précédentes,
caractérisé en ce que
l'on prévoit une résistance de couplage (R4), qui relie l'émetteur du transistor de mesure de la température (T9) à la base du transistor de puissance (T1, T2, T3).

7. Circuit intégré selon les revendications 4 à 6,
caractérisé en ce qu'
un troisième noeud (K3) du diviseur de tension (R7, R8, R9A, R9B) est relié au collecteur de l'autre transistor (T10).

8. Circuit intégré selon l'une des revendications précédentes,
caractérisé en ce que
le transistor de puissance (T1, T2, T3) est constitué sous la forme d'un transistor de Darlington.

9. Circuit intégré selon l'une des revendications précédentes,
caractérisé en ce que
le transistor de réglage de l'intensité (T5) commande un autre transistor de réglage de l'intensité (T6).

Fig. 1

EP 0 741 881 B1

Fig. 2

Fig. 3